# FASCICULE DE BREVET EUROPEEN

(11) **EP 0 739 042 B1**
(45) Date de publication et mention de la délivrance du brevet: **02.04.2008**
(21) Numéro de dépôt: 96400829.6
(22) Date de dépôt: 18.04.1996
(51) Int. Cl.: H01L 31/048, B32B 27/40, C09J 175/08

(54) **Procédé de fabrication d'un module solaire**
Herstellungsverfahren eines Solarmoduls
Method of fabrication of a solar module

(30) Priorité: 22.04.1995 DE 19514908
(43) Date de publication de la demande: 23.10.1996
(73) Titulaire: SAINT-GOBAIN GLASS FRANCE, 92400 Courbevoie (FR)
(72) Inventeur: Vaverka, Ingrid, 52074 Aachen (DE); Broering, Karin, 52072 Aachen (DE); Gelderie, Udo, 52080 Aachen (DE); Mattes Guenter, 52072 Aachen (DE); Reul, Bernhard, 52062 Aachen (DE)
(74) Mandataire: Le Cam, Stéphane Georges Elie

(56) Documents cités:
- EP-A- 0 269 469
- EP-A- 0 451 030
- DE-A- 3 817 953
- EXTENDED ABSTRACTS, vol. 82-1, Mai 1982, PRINCETON, NEW JERSEY US, pages 84-85, XP002005969 E.F.CUDDIHY ET AL.: "encapsulation material for terrestrial photovoltaic modules"
- PATENT ABSTRACTS OF JAPAN vol. 12, no. 279 (C-517), 1 Août 1988 & JP-A-63 057625 (KAO CORP.), 12 Mars 1988,
- PATENT ABSTRACTS OF JAPAN vol. 15, no. 131 (P-1186), 29 Mars 1991 & JP-A-03 013956 (CANON INC.), 22 Janvier 1991,
- PATENT ABSTRACTS OF JAPAN vol. 6, no. 250 (C-139), 9 Décembre 1982 & JP-A-57 147569 (HITACHI DENSEN KK), 11 Septembre 1982,

## Description

L'invention a trait à la fabrication d'un module solaire comprenant une plaque de verre frontale, une plaque-support arrière, ainsi que des cellules solaires placées entre ces plaques, l'espace creux entre ces mêmes plaques étant rempli d'une résine coulée apte à durcir.

Des modules solaires de ce type sont connus sous différentes formes et peuvent être également employés dans le secteur du bâtiment et de l'automobile, afin de produire du courant électrique à partir de l'énergie solaire. Ici, les cellules solaires sont placées entre les deux plaques et enrobées dans une couche de résine coulée, afin de les protéger des influences atmosphériques.

La résine coulée doit satisfaire toute une série d'exigences. Ainsi, par exemple, il lui faut, tout comme la plaque de verre frontale, posséder une forte transparence aux rayons lumineux, notamment dans le domaine des proches infrarouges, afin de permettre un haut rendement pour les cellules solaires. De plus, la résine coulée doit se montrer insensible aux rayons ultraviolets et à l'humidité. Enfin, une adhérence correcte et durable à la plaque de verre frontale et aux cellules solaires doit être assurée. En outre, la résine durcie doit présenter une élasticité telle que les contraintes mécaniques intervenant en raison des différences de coefficients de dilatation thermique des différents matériaux soient faibles dans la couche de polymère et qu'elles ne puissent donc causer de déformation du module ni de décollement des surfaces adhésives.

Le brevet DE 27 12 172 A1 présente le moyen d'utiliser, en tant que matériau d'encapsulation des cellules solaires, des polycarbonates, des silicones, des époxydes, des polyesters, des résines acryliques et des produits polymérisables de molécules en chaîne, avec principalement des hydrocarbures liés par covalence, sans atome d'halogène ajouté, comme par exemple du polypropylène, du polyisoprène ou du polybutadiène.

Le brevet DE 28 25 034 A1 propose quant à lui d'employer, pour enrober les cellules solaires entre les deux plaques, une résine contenant des composants d'acide acrylique. Ce type de résine peut posséder comme composant principal un mélange de méthacrylméthacrylate et de prépolymère de polyuréthane.

Le document DE 34 28 775 A1 préconise en revanche l'emploi d'EVA, d'EMA, de résines acryliques, d'élastomères de silicones, de PVB, de résines époxydiques ou de polyesteruréthanes aliphatiques pour fabriquer des modules solaires possédant la structure citée plus haut, afin d'insérer les cellules solaires entre les deux plaques.

Le document EP-A2-0 269 469 décrit une couche de couverture transparente en polyuréthane élastique souple pour substrats transparents de verre ou de matière plastique.

Le document E.F CUDDIHY et Al « Encapsulation material for terrestrial photovoltaic modules » Extended Abstracts, vol 82-1, mai 1982, pages 84-85, Princeton, New

Jersey US décrit l'emploi d'une résine polyétherpolyuréthane pour encapsuler des modules solaires.

Les exigences concernant les propriétés de la résine coulée pour la production de modules solaires sont d'autant plus élevées que les modules sont de grande taille. Tandis que les résines connues donnent des résultats tout à fait satisfaisants quant à la réalisation de modules solaires de petit format, la majorité des résines connues pour cet objectif pose des problèmes lorsqu'il s'agit de fabriquer des modules plus grands, comme c'est notamment le cas dans le secteur du bâtiment. On a ainsi pu constater qu'en utilisant des acrylates, tels qu'on les emploie en pratique, la réduction en volume de la résine, lors de son durcissement, provoquait d'importantes contraintes qui, au fil du temps, causaient des phénomènes de décollement entre la résine et les cellules solaires.

Il n'est, dans ce cas, possible d'éviter de tels phénomènes qu'en coulant des résines d'acrylate très plastiques, très souples.

Mais alors, la couche de résine ne possède plus qu'une résistance mécanique très réduite, si bien que le module solaire ne peut présenter les propriétés du verre de sécurité, qui sont pourtant recommandées pour l'installation en façades.

D'autres matériaux, tels que les silicones, ne sont pas non plus adaptés à une utilisation pour des modules solaires de grand format, également en raison de propriétés mécaniques insuffisantes (notamment à cause d'une moindre résistance à l'arrachement et d'une mauvaise compacité). L'usage de polyesteruréthanes aliphatiques ne s'est pas avéré plus satisfaisant. S'il est vrai que des résines à base de polyestheruréthanes sont aussi connues pour durcir sans pratiquement subir la moindre réduction de volume, on a cependant pu constater que des polyuréthanes à base de polyesterpolyol se désagrégeaient progressivement par hydrolyse. C'est pourquoi des modules solaires comportant une couche intermédiaire faite de polyesterpolyuréthanes présentent l'inconvénient de ne pas pouvoir être utilisés sans une étanchéification supplémentaire des bords, car, dans le cas contraire, il serait impossible d'éviter qu'à long terme, la région des bords du module soit endommagée par l'humidité.

L'invention a pour objectif de trouver un matériau qui s'adapte, du point de vue des différents aspects et plus particulièrement en tant que résine coulée, à l'enrobage des cellules photoélectriques pour des modules solaires. Le matériau polymère ne devra (entre autres) pas causer de variations en volume lors du durcissement, ni se modifier sous l'effet de l'humidité et se devra de posséder, lors du processus de fabrication du module solaire, un comportement adapté du point de vue de la viscosité, une haute adhérence à la surface des plaques et des cellules solaires, une forte résistance à l'arrachement, de bonnes propriétés de compacité, ainsi que des propriétés particulières et marquées du point de vue de l'élasticité caoutchouteuse. En outre, ce matériau devra présenter une forte transparence aux rayons lumineux, se montrer insensible aux rayonnements ultraviolets et conserver à long terme les propriétés mentionnées, c'est-à-dire résister dans une large mesure à l'altération.

On a pu constater que des modules solaires contenant un polyétherpolyuréthane comme résine coulée présentaient à tout point de vue les propriétés souhaitées, à l'inverse des autres résines connues. Ainsi, notamment, on ne remarque ni phénomène de décollement, ni jaunissement après exécution d'un essai de vieillissement poussé, obtenu sous l'effet de la chaleur, du froid, des variations de températures, de rayonnements et de l'humidité. L'humidité ne provoque pas non plus d'obscurcissement dans la zone des bords. La viscosité de la résine peut quant à elle varier selon le choix des dosages dans le mélange des composants d'isocyanate et de polyol, tout en respectant les limites souhaitées, bien entendu. Le procédé de l'invention est défini dans la revendication 1.

On emploie comme résine coulée, conformément à un aspect de l'invention, des mélanges par réaction constitués d'un ou plusieurs prépolymère(s) d'isocyanate aliphatique(s) et d'un ou plusieurs polyétherpolyol(s). Certains mélanges par réaction ont notamment fait leurs preuves, pour lesquels les composants d'isocyanate sont faits d'un polyisocyanate aliphatique trifonctionnel à base de hexaméthylènediisocyanate-1,6 à structure biuret ou isocyanurate, avec une teneur en groupes NCO pouvant aller de 12,8 à 28% du poids et un poids moléculaire moyen de 450 à 1000 g/mol, tandis que les composants de polyol consistent en un polyétherpolyol à base de triméthylolpropane et d'oxyde de propylène, avec une teneur en groupes OH de 5,1 à 12,8% du poids et un poids moléculaire moyen d'environ 400 à 1000 g/mol.

Conformément à un aspect de l'invention, on ajoute au mélange par réaction, en tant qu'additifs, un catalyseur pour l'accélération de la réaction de durcissement, ce catalyseur pouvant être du dibutylétaindilaurate, un produit absorbant les rayons ultraviolets, en particulier à base d'une amine à encombrement stérique, ainsi qu'un silane, afin d'augmenter l'adhérence de la couche de résine à la plaque de verre, à la plaque-support et aux cellules solaires.

La réaction de durcissement se fait de préférence à une température élevée, pouvant être comprise entre environ 30° et 50°C. Il s'est en outre avéré avantageux d'effectuer selon l'invention cette réaction dans un autoclave, sous une légère surpression, de l'ordre de 3·10⁴ Pa à 1·10⁵ Pa (0,3 à 1 bar). Par cette surpression, lors de la polymérisation, on parvient à supprimer totalement une éventuelle formation de bulles dans la résine, qui serait causée par le dégagement de dioxyde de carbone.

Un exemple de réalisation intéressant selon le procédé conforme à l'invention est présenté ci-dessous :

On construit un module solaire d'1 x 1 m² : la plaque-support arrière, comme la plaque avant, sont toutes deux en matériau transparent, ici des feuilles de verre flotté d'environ 5 mm d'épaisseur. La plaque de verre avant est de préférence constituée d'un verre extra-blanc, c'est-à-dire capable d'une transmission particulièrement haute pour le rayonnement lumineux et thermique.

On place et fixe tout d'abord les cellules solaires sur la plaque-support, elle-même posée à l'horizontale dans la position souhaitée, puis on connecte électriquement les cellules entre elles et on réalise les branchements électriques vers l'extérieur à l'endroit souhaité, sur le bord de la plaque-support en verre. Une bande de colle est ensuite déposée le long du bord de vitre, par exemple par extrusion, la bande servant d'une part à garantir l'étanchéité des bords du module solaire et d'autre part à maintenir un écartement entre les deux feuilles.

On installe dans deux coins, opposés en diagonale, des segments de tube métallique, qui permettront ultérieurement de remplir l'espace creux compris entre les deux feuilles et de le vider de son air. La plaque avant est ensuite installée, puis ces deux feuilles sont serrées l'une contre l'autre de manière à laisser entre elles l'espace souhaité.

Pour produire la masse de résine coulée, dont on remplit l'espace creux compris entre les feuilles de verre, on mélange par agitation, pendant 10 minutes et à température ambiante, 500 grammes d'un polyisocyanate trifonctionnel (pour l'essentiel), contenant des groupes de biuret, à base de hexaméthylènediisocyanate-1,6 avec une teneur en groupes NCO libres constituant 23% du poids et possédant un poids moléculaire moyen de 550 g/mol, avec 800 grammes d'un polyol trifonctionnel à base de triméthylolpropane avec une teneur en groupes OH constituant 11,8% du poids et possédant un poids moléculaire moyen de 430 g/mol. On utilise comme additifs 0,5 g de dibutylétaindilaurate (comme catalyseur), 50 g d'une amine à encombrement stérique (en tant que moyen de protection vis-à-vis de la lumière) et 5 g d'un aminosilane (comme promoteur d'adhérence). Le rapport NCO/OH dans le mélange est de 0,5. Après homogénéisation, ce mélange présente une viscosité d'environ 1400 mPa.s (1400 CP), à une température de 20°C.

Ce mélange de résine est ensuite versé dans l'espace creux compris entre les deux feuilles de verre, le module solaire étant de préférence placé dans une position à peu près verticale. La masse de résine est injectée par le tube inférieur, tandis que celui du haut permet l'évacuation de l'air. Après ce remplissage, les deux tubes métalliques sont ôtés et les ouvertures colmatées au moyen d'une masse de colle.

Le module solaire rempli de cette manière et donc exempt de bulles, est ensuite installé dans un autoclave. La température de ce dernier est portée à environ 40°C et la surpression dans l'autoclave atteint près de 60000Pa (0,6 bar). Dans ces conditions, la résine se polymérise et durcit totalement après 60 minutes.

Lorsqu'on le sort de l'autoclave, le module solaire est prêt à l'emploi.

## Revendications

1. Procédé de fabrication d'un module solaire comprenant une plaque avant et une plaque-support arrière, de préférence en verre, et des cellules solaires placées entre elles, l'espace creux ménagé entre la plaque avant et la plaque-support étant rempli d'une résine polyétherpolyuréthane coulée apte à durcir, **caractérisé en ce que** le module solaire est soumis, au cours de la réaction de durcissement de la résine, à une surpression pouvant aller d'environ 3·10⁴ Pa à 1·10⁵ Pa (0,3 à 1 bar).

2. Procédé selon la revendication 1, **caractérisé en ce qu'**un mélange par réaction, composé d'un ou plusieurs prépolymère(s) d'isocyanate aliphatique(s) et d'un ou plusieurs polyétherpolyol(s), est employé comme résine coulée.

3. Procédé selon la revendication 1 ou 2, **caractérisé en ce que** l'on emploie, comme composant d'isocyanate, un polyisocyanate aliphatique trifonctionnel à base de hexaméthylènediisocyanate-1,6, à structure biuret ou isocyanurate, avec une teneur en groupes NCO de 12,6 à 28% du poids et un poids moléculaire moyen d'environ 450 à 1000 g/mol.

4. Procédé selon l'une quelconque des revendications 1 à 3, **caractérisé en ce que** l'on emploie, comme composant de polyol, un polyétherpolyol à base de triméthylolpropane et d'oxyde de propylène avec une teneur en groupes OH pouvant aller de 5,1 à 12,8% du poids et un poids moléculaire moyen d'environ 400 à 1000 g/mol.

5. Procédé selon une ou plusieurs des revendications 1 à 4, **caractérisé en ce que** l'on emploie un mélange de résine avec un rapport NCO/OH pouvant aller de 0,3 à 0,8.

6. Procédé selon la revendication 5, **caractérisé en ce que** l'on emploie un mélange de résine avec un rapport NCO/OH de 0,5.

7. Procédé selon l'une quelconque des revendications 1 à 6, **caractérisé en ce que** l'on ajoute à la résine coulée un promoteur d'adhérence, tel qu'un silane, de préférence un aminosilane, afin d'augmenter l'adhérence de la résine à la plaque de verre avant, à la plaque-support et aux cellules solaires.

8. Procédé selon l'une quelconque des revendications 1 à 7, **caractérisé en ce que** l'on ajoute à la résine un additif protégeant des rayons ultraviolets, additif pouvant notamment être à base d'une amine à encombrement stérique.

9. Procédé selon une ou plusieurs des revendications 1 à 8, **caractérisé en ce qu'**au mélange par réaction est ajouté du dibutylétaindilaurate comme catalyseur, afin d'accélérer la réaction de durcissement.

## Claims

1. Process for manufacturing a solar module comprising a front plate and a rear support plate, preferably made of glass, and the solar cells placed between them, the hollow space created between the front plate and the rear support plate being filled with a polyether/polyurethane casting resin capable of being cured, **characterized in that** the solar module is subjected, during the curing reaction of the resin, to an overpressure which may range from around 3 × 10⁴ Pa to 1 × 10⁵ Pa (0.3 to 1 bar).

2. Process according to Claim 1, **characterized in that** a reaction mixture composed of one or more aliphatic isocyanate prepolymer(s) and one or more polyether polyol(s) is used as a casting resin.

3. Process according to Claim 1 or 2, **characterized in that** used as an isocyanate component is a trifunctional aliphatic polyisocyanate based on 1,6-hexamethylene diisocyanate, having a biuret or isocyanurate structure, with a content of NCO groups of 12.6 to 28 wt% and an average molecular weight of around 450 to 1000 g/mol.

4. Process according to any one of Claims 1 to 3, **characterized in that** used as a polyol component is a polyether polyol based on trimethylolpropane and on propylene oxide with a content of OH groups which may range from 5.1 to 12.8 wt% and an average molecular weight of around 400 to 1000 g/mol.

5. Process according to one or more -of Claims 1 to 4, **characterized in that** a resin mixture with an NCO/OH ratio which may range from 0.3 to 0.8 is used.

6. Process according to Claim 5, **characterized in that** a resin mixture with an NCO/OH ratio of 0.5 is used.

7. Process according to any one of Claims 1 to 6, **characterized in that** added to the casting resin is an adhesion promoter, such as a silane, preferably an aminosilane, in order to increase the adhesion of the resin to the front glass plate, to the support plate and to the solar cells.

8. Process according to any one of Claims 1 to 7, **characterized in that** added to the resin is an additive that protects against ultraviolet radiation, an additive which may especially be based on a sterically hindered amine.

9. Process according to one or more of Claims 1 to 8, **characterized in that** dibutyltin dilaurate is added to the reaction mixture as a catalyst in order to accelerate the curing reaction.

## Patentansprüche

1. Verfahren zur Herstellung eines Solarmoduls, das eine Frontseite und eine tragende Rückseite, vorzugsweise aus Glas, und zwischen ihnen angeordnete Solarzellen umfasst, wobei der zwischen der Frontseite und der tragenden Rückseite vorhandene Hohlraum mit einem aushärtbaren Polyetherpolyurethan-Gießharz ausgefüllt ist, **dadurch gekennzeichnet, dass** das Solarmodul während der Reaktion des Aushärtens des Harzes einem Überdruck ausgesetzt wird, der etwa 3·10⁴ Pa bis 1·10⁵ Pa (0,3 bis 1 bar) betragen kann.

2. Verfahren nach Anspruch 1, **dadurch gekennzeichnet, dass** ein Reaktionsgemisch, das sich aus einem oder mehreren aliphatischen Isocyanatprepolymeren und einem oder mehreren Polyetherpolyolen zusammensetzt, als Gießharz verwendet wird.

3. Verfahren nach Anspruch 1 oder 2, **dadurch gekennzeichnet, dass** als Isocyanatkomponente ein trifunktionelles aliphatisches Polyisocyanat auf der Basis von 1,6-Hexamethylendiisocyanat mit Biuret- oder Isocyanuratstruktur mit einem Gehalt an NCO-Gruppen von 12,6 bis 28 Gew.-% und einem mittleren Molekulargewicht von etwa 450 bis 1000 g/mol verwendet wird.

4. Verfahren nach einem der Ansprüche 1 bis 3, **dadurch gekennzeichnet, dass** als Polyolkomponente ein Polyetherpolyol auf der Basis von Trimethylolpropan und Propylenoxid mit einem Gehalt an OH-Gruppen, der 5,1 bis 12,8 Gew.-% betragen kann, und einem mittleren Molekulargewicht von etwa 400 bis 1000 g/mol verwendet wird.

5. Verfahren nach einem oder mehreren der Ansprüche 1 bis 4, **dadurch gekennzeichnet, dass** ein Harzgemisch mit einem Verhältnis von NCO/OH, das 0,3 bis 0,8 betragen kann, verwendet wird.

6. Verfahren nach Anspruch 5, **dadurch gekennzeichnet, dass** ein Harzgemisch mit einem Verhältnis von NCO/OH von 0,5 verwendet wird.

7. Verfahren nach einem der Ansprüche 1 bis 6, **dadurch gekennzeichnet, dass** zu dem Gießharz ein Haftungsverstärker wie ein Silan, vorzugsweise ein Aminosilan, zugegeben wird, um die Haftung des Harzes an der Frontglasseite, der tragenden Rückseite und den Solarzellen zu verstärken.

8. Verfahren nach einem der Ansprüche 1 bis 7, **dadurch gekennzeichnet, dass** zu dem Harz ein Additiv zugegeben wird, das vor Ultraviolettstrahlen schützt, wobei das Additiv insbesondere auf der Basis eines Amins mit sterischer Raumerfüllung sein kann.

9. Verfahren nach einem oder mehreren der Ansprüche 1 bis 8, **dadurch gekennzeichnet, dass**, um die Aushärtungsreaktion zu beschleunigen, zu dem Reaktionsgemisch Dibutylzinndilaurat als Katalysator zugegeben wird.
